# NEUE EUROPÄISCHE PATENTSCHRIFT

(11) **EP 2 111 517 B2**
(45) Veröffentlichungstag und Bekanntmachung des Hinweises auf die Entscheidung über den Einspruch: **13.08.2014**
(45) Hinweis auf die Patenterteilung: 17.08.2011
(21) Anmeldenummer: 08860209.9
(22) Anmeldetag: 11.12.2008
(51) Int. Cl.: F21K 99/00

(54) **LEUCHTMITTEL**
ILLUMINATION MEANS
MOYENS D'ECLAIRAGE

(30) Priorität: 13.12.2007 DE 102007060585
(43) Veröffentlichungstag der Anmeldung: 28.10.2009
(73) Patentinhaber: Emde, Thomas, 60389 Frankfurt (DE)
(72) Erfinder: Emde, Thomas, 60389 Frankfurt (DE)
(74) Vertreter: Fritz, Edmund Lothar
(86) Internationale Anmeldenummer: PCT/EP2008/010537
(87) Internationale Veröffentlichungsnummer: WO 2009/074322

(56) Entgegenhaltungen:
- EP-A- 1 367 676
- EP-A- 1 367 677

## Beschreibung

Die vorliegende Erfindung betrifft ein Leuchtmittel auf Basis organischer Leuchtdioden (OLED) umfassend wenigstens eine organische Licht emittierende Schicht (OLED-Schicht) sowie mindestens eine Anodenschicht und/oder eine Kathodenschicht auf, an oder in einem Träger sowie Kontaktmittel für eine elektrische Kontaktierung der Elektrodenschichten. Die Erfindung betrifft weiterhin ein Verfahren zur Herstellung eines Leuchtmittels der vorgenannten Art.

Seit einiger Zeit hat die praktische Bedeutung der erst vor wenigen Jahren entwickelten OLEDs als Leuchtmittel zugenommen, da deren Lichtausbeute und Effizienz stetig zunimmt. So ist es beispielsweise bereits gelungen, OLEDs mit einem Wirkungsgrad von 35 Im/Watt und sogar bis zu mehr als 60 Im/Watt bei einer Helligkeit von 1000 cd/m² und einer Lebensdauer von 100.000 Stunden herzustellen. Die OLEDs werden in sehr dünnen Schichten von beispielweise nur einigen nm auf einen flächigen Träger aufgebracht. Als Träger werden meist dünne plattenartige rechteckige Substrate wie zum Beispiel Glasplatten verwendet. In den bislang bekannten Anwendungen von Leuchtmitteln auf der Basis von OLEDs betrachtet man diese folglich durchweg als flächige Lichtquelle, da man von den verfügbaren OLEDs auf plattenförmigem Träger der vorgenannten Art ausgeht.

Typische Anwendungen für derartige OLEDs als mehrschichtige flächige Lichtquelle auf rechteckigem starren Träger sind in der DE 60306720 T2 beschrieben. Es ist eine OLED-Schicht, zwei Elektrodenschichten sowie eine verkapselnde Abdeckung auf einen transparenten Träger aufgebracht. Dieser ist an einem Ende mit Kontakten an Zungenabschnitten versehen, die in eine Art Sockelleiste mit Öffnungen einsteckbar sind, so dass eine Kontaktierung stattfinden kann. Nachteilig bei diesen bekannten OLEDs ist zum einen die Tatsache, dass durch den Hersteller die OLED als ebene flächige plattenförmige Lichtquelle auf rechteckigem Träger definiert wird und damit für den späteren Nutzer bereits Einschränkungen bei der Verwendung einer solchen Lichtquelle vorgegeben sind. Zum anderen bestehen bei den bislang bekannten OLEDs dieser Art technische Probleme in den Bereichen der Kanten des plattenförmigen OLED-Trägers, da dort eine Grenzlinie der sehr dünnen Schicht der organischen Leuchtdiode besteht, die zu Unregelmäßigkeiten in der Lichtabstrahlung führen kann. Beispielsweise kann der Fluss der Ladungsträger in diesem Kantenbereich gestört sein. Es ist bei herkömmlichen OLEDs auf rechteckigem Träger bereits zu Schäden der Licht emittierenden Schicht in diesem Kantenbereich gekommen. Die Verkapselung der organischen Licht emittierenden Schicht ist in der Regel notwendig, da die organischen Materialien empfindlich sind gegen Feuchtigkeit und Sauerstoff.

In der DE 603 06 722 T2 ist eine Halbleiterlichtquelle zum Beleuchten eines Bereichs beschrieben mit einem starren Träger, einem an dem Träger befestigten biegsamen Substrat, einer organischen Leuchtdiodenschicht, die sich auf dem biegsamen Substrat befindet und eine erste und eine zweite Elektrode aufweist zum Übertragen elektrischer Energie auf die OLED-Schicht, einer verkapselnden Abdeckung auf der OLED-Schicht, einem ersten und zweiten Leiter, die mit der ersten und zweiten Elektrode elektrisch verbunden sind und sich über die verkapselnde Abdeckung hinaus erstrecken, und mit einem mit dem starren Träger verbundenen Stecker zur entnehmbaren Aufnahme in einer Fassung. Nach einer möglichen Variante der in diesem Dokument beschriebenen Lösung geht man so vor, dass man den ebenen rechteckigen Träger, der die OLED-Schicht trägt, mit einem Sockel versieht, der eine Fassung aufweist, die in ihren Abmessungen mit denjenigen einer herkömmlichen Fassung kompatibel ist, so dass man ein herkömmliches gegen ein so geschaffenes Leuchtmittel auf OLED-Basis austauschen kann.

EP 1367676 zeigt ein gerät mit flexibelen OLED.

Eine ebenfalls in dem vorgenannten Dokument beschriebene Variante sieht vor, die OLED-Schicht auf ein biegsames Substrat beispielsweise in Form einer Folie aufzubringen, die dann gegebenenfalls spiralförmig auf einen zum Beispiel zylindrischen Träger aus Glass gewickelt werden kann, wodurch man dann ein zylindrisches röhrenartiges Leuchtmittel auf OLED-Basis erhält, welches wiederum mit einer Fassung versehen werden kann und dann ein Leuchtmittel darstellt, welches gegen eine herkömmliche Glühlampe oder Leuchtstoffröhre ausgetauscht werden kann. Bei dieser Variante wird somit jedoch zunächst die als Substrat dienende Folie mit den für die Funktion der OLED notwendigen Schichten beschichtet und erst in einem weiteren Produktionsschritt kann dann ein solches mit OLED beschichtetes Substrat (die Folie), da es flexibel ist, auch auf einen zylindrischen Träger aufgebracht werden. Nachteilig bei den auf flexiblen Folien als Träger aufgebrachten OLEDs ist die Tatsache, dass das flexible Kunststoffsubstrat eine zu hohe Durchlässigkeit für Sauerstoff und Luftfeuchtigkeit aufweist und daher die organische Schicht in diesem Fall nicht ausreichend geschützt ist.

Es wurde auch bereits an die Verwendung von sehr dünnem Glas gedacht, um einen in gewissem Maße flexiblen Träger für die organische Schicht zu schaffen. Das Dünnglas lässt sich jedoch schwer verarbeiten und auch das herkömmlicherweise verwendete Anodenmaterial, z.B. Indiumzinnoxid ist ein Hartstoff und daher spröde, so dass es beim Ausrollen eines solchen Trägers zu Beschädigungen der Elektrodenschicht kommen kann.

Eine dritte in der DE 603 06 722 T2 beschriebene Variante sieht vor, zunächst wiederum einen rechteckigen mit Rahmen versehenen flächigen ebenen Träger herzustellen, der mit der OLED-Schicht und den Elektroden beschichtet ist, jedoch in miniaturisierter Form, und dann dieses quasi bereits ein Leuchtmittel darstellende ebene rechteckige OLED-Element in den Hohlraum eines Glaskolbens in Form einer Glühlampe einzubringen, die mit einem Sockel mit Fassung versehen ist, um so den Glühfaden der Glühlampe zu ersetzen und eine Glühlampe auf OLED-Basis zu schaffen. Diese Vorgehensweise erfordert jedoch nach der Herstellung einer quasi konventionellen OLED auf herkömmlichem flächigen Träger den zusätzlichen Arbeitsschritt der Einbringung dieses Elements in einen Hohlkörper, so dass der Herstellungsprozess vergleichsweise aufwändig ist. Ein weiterer Nachteil dieser Lösung besteht darin, dass man nur eine OLED mit einer vergleichsweise kleinen für die Lichtabgabe wirksamen Fläche verwendet. Da die Lichtstärke des Leuchtmittels proportional zu der OLED-Fläche ist, wird auch nur eine geringe Lichtausbeute erhalten.

Die in der DE 603 06 722 T2 beschriebenen Lösungsvarianten beinhalten zwar die grundsätzliche Idee, mit Hilfe organischer Leuchtdioden Leuchtmittel herzustellen, die das Erscheinungsbild eines herkömmlichen Leuchtmittels wie zum Beispiel der klassischen Glühlampe nachahmen und sich auch in ähnlichen Anwendungen einsetzen lassen, jedoch, wird immer zunächst die OLED-Schicht und die Elektrodenschichten auf ein biegsames Substrat (in Form einer Folie) aufgebracht und erst in einem zweiten Schritt wird dann dieses biegsame Substrat auf einen starren Träger mit zum Beispiel der Form eines Zylinders oder eines Kegelstumpfs aufgebracht, beispielsweise aufgeklebt. Dadurch bleiben die vorgeschilderten Nachteile des biegsamen Substrats erhalten. Auch ist es weiterhin notwendig, die OLED-Schichten auf dem biegsamen Träger mit einer Schutzschicht zu versehen (zu verkapseln).

Hier setzt die vorliegende Erfindung ein. Aufgabe der Erfindung ist es, ausgehend von dem vorgenannten Stand der Technik ein Leuchtmittel auf OLED-Basis zu schaffen, das die genannten Nachteile nicht aufweist, vielseitigere Anwendungen zulässt und dabei eine rationelle Serienfertigung zulässt.

Die Lösung der Aufgabe liefert ein erfindungsgemäßes Leuchtmittel der eingangs genannten Gattung mit den kennzeichnenden Merkmalen des Hauptanspruchs.

Erfindungsgemäß ist vorgesehen, dass eine Schicht oder Schichtanordnung umfassend mindestens die Licht emittierende Schicht auf die Innenseite einer als Träger dienenden formstabilen Rotationsfläche aufgebracht ist.

Unter Rotationsfläche wird dabei die Oberfläche eines Rotationskörpers im Sinne der mathematischen Definition verstanden, der durch Rotation einer erzeugenden Kurve um eine Rotationsachse entsteht. Beispiele für derartige Rotationskörper sind Kugel, Zylinder, Torus, Ellipsoid, davon abgeleitete Rotationskörper sowie solche mit komplexeren Formen. Die Licht emittierende Schicht (bzw. Schichten) bzw. die Schichtanordnung einer organischen Leuchtdiode wird dabei (bei mehreren Schichten sukzessive) auf die Innenseite dieses Rotationskörpers aufgebracht, welcher als Träger für diese Schicht(en) dient. Bei Aufbringung mehrerer Schichten wird nur die erste (äußere) Schicht unmittelbar auf den Träger aufgebracht und die nachfolgenden Schichten werden dann auf die jeweils bereits zuvor aufgebrachte Schicht aufgebracht.

Die Rotationsfläche ist formstabil, das heißt, sie hat bereits ihre Form in der Funktion als Träger des Leuchtmittels, wenn die Schicht(en) aufgebracht werden. Es wird also erst ein Rotationskörper geformt, vorzugsweise aus Glas, Kunststoff oder einem anderen geeigneten lichtdurchlässigen Material, der danach beschichtet wird. In dem oben erwähnten Stand der Technik gemäß der DE 603 06 722T2 wird hingegen anders vorgegangen, da zunächst ein biegsames und somit verformbares Substrat beschichtet und erst danach in die gewünschte Form gebracht wird. Dies ist nur bei biegsamen Substraten wie Folien oder dergleichen möglich, die die erwähnten Nachteile haben. Bei einem Träger wie Glas oder Kunststoff käme diese herkömmliche Vorgehensweise nicht in Betracht, denn eine Verformung nach der Aufbringung würde eine entsprechend hohe Temperatur erfordern, bei der die OLED-Schichten, insbesondere die organische Emitterschicht zerstört würden.

Vorzugsweise dient erfindungsgemäß als Träger die Innenfläche eines weitgehend oder vollständig geschlossenen Hohlkörpers bevorzugt aus Glas, Kunststoff oder einem anderen lichtdurchlässigen Material. Dieser Hohlkörper kann beispielsweise aus einem formstabilen Kunststoff oder Keramik oder aus einem anderen lichtdurchlässigen (transparenten oder transluzenten) Werkstoff bestehen. Bei Verwendung von Kunststoffen besteht allerdings nach dem derzeitigen Stand der Wissenschaft die Bedingung, dass der Kunststoff sauerstoffundurchlässig ist, was bei vielen herkömmlichen Kunststoffen nicht in ausreichendem Maße der Fall ist. Jedoch wird auch diese Bedingung hinfällig, wenn OLED-Substanzen verfügbar sind, die gegen Sauerstoff und Feuchtigkeit unempfindlich sind.

Der Hohlkörper wird dabei vorzugsweise so hergestellt, dass die Form des gewünschten Rotationskörpers vorgegeben ist, wobei lediglich in vorgesehenen Bereichen eine oder mehrere Öffnungen verbleiben, die vergleichsweise klein sind, von einer Größe, die ausreicht, um die innere Oberfläche des Hohlkörpers danach noch beschichten, zum Beispiel bedampfen zu können, beispielsweise, indem man mit einem geeigneten Beschichtungselement durch die Öffnung in den Hohlraum fährt. Danach können dann die verbleibenden Öffnungen geschlossen werden. Es liegt dann ein vollständig geschlossener innen beschichteter Hohlkörper vor, der luftdicht und feuchtigkeitsdicht verschlossen sein kann. Daraus ergeben sich diverse erfindungsgemäße Vorteile. Es ist insbesondere nicht mehr unbedingt notwendig die empfindlichen Schichten der OLED-Anordnung mit einer Schutzschicht zu versehen oder zu verkapseln. Es ist kein weiteres Substrat als Träger notwendig. Es erübrigt sich die sonst häufig verwendete Sandwichanordnung, bei der die OLED-Schichten zwischen zwei Schichten, nämlich einer Trägerschicht und einer Schutzschicht eingebettet sind. Die innere Oberfläche des Rotationskörpers bildet die Trägerschicht und eine Abdeckung an der Innenseite der Schichtanordnung erübrigt sich. Der Innenraum des Hohlkörpers kann auch mit einer von Luft und Sauerstoff verschiedenen gasförmigen Substanz befüllt werden, welche beispielsweise auch unter Unterdruck oder Überdruck stehen kann, so dass die empfindlichen Schichten der OLED-Anordnung dadurch geschützt werden. Es ist demnach vorteilhaft, dass die als Träger für die Beschichtung dienende Hülle des Hohlkörpers auch gleichzeitig die OLED-Schicht zur äußeren Umgebung hin schützt. Der sonst notwendige aufwendige Schritt einer Verkapselung der OLED-Schicht oder Schicht-Anordnung kann damit entfallen.

Gemäß einer Variante der Erfindung könnte auch der verwendete Hohlkörper bereits eine der Elektrodenschichten umfassen. Entsprechend geeignete elektrisch leitende und lichtdurchlässige Materialien wie zum Beispiel Gläser, Kunststoffe, Keramik oder andere sind denkbar, so dass in diesem Fall die Innenseite des Hohlkörpers direkt mit der Emitterschicht und den weiteren Schichten versehen werden kann. Eine Isolierung nach außen könnte erfolgen, ist aber auch nicht zwingend notwendig, da die OLEDs im Niedervoltbereich betrieben werden und es somit auch ungefährlich wäre, wenn man ohne Isolierung arbeiten würde. Bei dieser Variante ist es möglich, dass der Hohlkörper nur mit einer Schicht, nämlich der Licht emittierenden Schicht beschichtet wird, wenn der Träger(Hohlkörper) selbst die erste Elektrode bildet und die zweite Elektrode mit Abstand dazu angeordnet ist, beispielsweise als punktförmige Elektrode im Mittelpunkt eines kugelförmigen Hohlkörpers oder als stabförmige Elektrode im Achsbereich eines zylindrischen Hohlkörpers.

Ein weiterer Vorteil der Erfindung besteht gegenüber herkömmlichen OLEDs dann, wenn eine der beiden Elektroden durch eine nicht transparente Beschichtung auf dem Träger gebildet wird. Bei der herkömmlichen OLED mit einem Schichtaufbau auf einem flachen plattenförmigen Träger ist bei einer nicht transparenten Elektrode nämlich nur die Lichtabstrahlung zu einer Seite hin möglich. Die zweite Elektrode muss dann transparent sein, da sie meist über der Licht emittierenden Schicht aufgebracht ist. Bei der erfindungsgemäßen Lösung kann hingegen auch eine nicht transparente Elektrode auf die Licht emittierende Schicht aufgebracht werden, da die Elektrodenschicht dann innen (in Bezug auf die Trägerfläche des Hohlkörpers) liegt und somit die Licht emittierende Schicht ungehindert nach außen hin abstrahlen kann. Dies ermöglicht es, auf andere Materialien für diese Elektrode zurückzugreifen.

Die für die Funktion der OLED-Anordnung notwendigen Schichten, dies sind beispielsweise wenigstens eine erste Elektrodenschicht, wenigstens eine organische Emitterschicht und wenigstens eine zweite Elektrodenschicht werden also in der entsprechenden Weise nach den an sich bekannten Methoden in der erforderlichen Reihenfolge nacheinander auf die innere Oberfläche des Hohlkörpers aufgebracht, beispielsweise aufgedampft oder durch Sublimation aufgebracht, aufgesprüht, aufgedruckt (beispielsweise Tampondruck) oder durch Spin-coating, Sputtern, oder durch ein Beschichtungsverfahren aufgebracht, bei welchem ein Schleudern, Rotieren oder Schütteln des Rotationskörpers erfolgt. Danach wird der Hohlkörper vorzugsweise vollständig verschlossen, um die zuvor aufgebrachten Schichten zu schützen und eine zusätzliche Schutzschicht oder Verkapselung zu vermeiden. Man erhält auf diese Weise ein Leuchtmittel, welches beispielsweise die Form einer herkömmlichen Glühlampe oder Leuchtstoffröhre (Kugelform, Kolbenform, Birnenform, Zylinderform) aufweist, jedoch die lichttechnischen Eigenschaften und alle Vorteile der OLEDs hat.

Bereits die erfindungsgemäß anwendbaren Verfahren zur Beschichtung können in effektiverer Weise eingesetzt werden als bei der herkömmlichen Beschichtung ebener plattänförmiger Träger mit OLED. Bei diesen ging bei der Beschichtung immer ein vergleichsweise hoher Anteil des wertvollen Beschichtungsmaterials verloren, da dieses nicht in der gewünschten Weise auf dem Substrat niedergeschlagen wurde. Meist war auch keine Wiederverwendung des durch Streuung bei der Beschichtung verlorenen Materials möglich. Diese Problematik wird durch die erfindungsgemäße Lösung überwunden, denn bei Beschichtung der Innenfläche eines weitgehend geschlossenen hohlen Rotationskörpers geht kein Beschichtungsmaterial verloren. Wird die Beschichtungseinrichtung in den Hohlkörper eingeführt, dann kann das Beschichtungsmaterial sich zum Beispiel von einem Sprühkopf aus in alle Raumrichtungen gleichmäßig verteilen und ebenso auf der zu beschichtenden Fläche gleichmäßig niederschlagen.

Ein weiterer wesentlicher Vorteil der erfindungsgemäßen Lösung liegt darin, dass nicht mehr ein flächiges plattenförmiges Leuchtmittel vorliegt, welches entsprechende Einschränkungen in den Beleuchtungsanwendungen mit sich bringt, sondern es wird beispielsweise ein einer Glühlampe oder Leuchtstofflampe in der Form ähnliches Leuchtmittel geschaffen, welches als quasi punktförmige oder stabförmige Lichtquelle dient, so dass das erfindungsgemäße Leuchtmittel auf OLED-Basis für die gleichen lichttechnischen Anwendungen in Betracht kommt wie eine herkömmliche Glühlampe oder Leuchtstofflampe. Dies führt auch dazu, dass die Nachfrage steigt und die Herstellung in größeren Stückzahlen möglich sein wird, wodurch sich die bislang noch vergleichsweise hohen Herstellungskosten senken lassen. Es wird ein energiesparendes Leuchtmittel mit hoher Lichtstärke zur Verfügung gestellt, welches zudem weißes oder farbiges Licht in der gewünschten Lichtfarbe unmittelbar zur Verfügung stellt, ohne dass es der Mischung und Ansteuerung bedarf, wie zum Beispiel bislang bei der Verwendung herkömmlicher LEDs. Das Leuchtmittel ist für den Verbraucher funktionell und auch in der optischen Anmutung völlig kompatibel zu herkömmlichen Lampen, wodurch eine raschere Durchsetzung am Markt zu erwarten ist. Hier liegt ein wesentlicher Vorteil gegenüber den bislang bekannten plattenförmigen rechteckigen OLEDs. Da die Schichten der OLED-Anordnung in dem (geschlossenen) Hohlraum geschützt sind, ist auch eine Erhöhung der Lebensdauer zu erwarten.

Ein erheblicher weiterer Vorteil auch gegenüber der aus der DE 603 06 722 T2 bekannten Lösung ergibt sich daraus, dass man erfindungsgemäß quasi die gesamte innere Oberfläche des mit den OLED-Schichten versehenen Hohlkörpers für die Lichtabgabe nutzt und somit eine entsprechend maximierte Lichtausbeute erzielen kann. Demgegenüber ist die Größe der für die Lichtabgabe wirksamen Fläche bei Einbringung einer rechteckigen OLED in den Hohlkörper einer Glühlampe nur ein Bruchteil der erfindungsgemäß erzielbaren Fläche.

Ein wesentlicher Vorteil liegt auch darin, dass man die OLED-Schichten auf eine gekrümmte in sich geschlossene Fläche, nämlich die Innenfläche des Hohlkörpers aufbringt. Als Innenfläche eines Rotationskörpers hat diese Fläche nur eine minimale Kantenlänge, nämlich bei beispielsweise einer Kolbenform nur im Halsbereich des Kolbens (zum Sockel hin), wo die Schichten enden. Im Verhältnis zur gesamten beschichteten Oberfläche ist diese Kantenlänge sehr gering, so dass die zuvor geschilderten Probleme in den Grenzbereichen, dort wo die Schichten enden, nicht mehr bzw. nur in viel geringerem Ausmaß relevant sind. Aufgrund der kaum noch vorhandenen Kantenbereiche (Randbereiche) der Beschichtung ist davon auszugehen, dass die Lebensdauer eines erfindungsgemäßen Leuchtmittels wesentlich höher ist als diejenige herkömmlicher flacher meist rechteckiger OLEDs.

Ein weiterer wesentlicher Vorteil der OLED gegenüber der LED als Leuchtmittel ist das bereitere Farbspektrum des emittierten Lichts, welches bei der OLED dem natürlichen Tageslicht näher kommt. LEDs sind hingegen meist weitgehend monochromatisch in ihrer Abstrahlung. Diese Vorteile gelten auch gegenüber Energiesparlampen und Halogenlampen.

Eine alternative Variante der Erfindung ermöglicht die Herstellung von Leuchtmitteln mit im wesentlichen zylindrischer Form, die in der optischen Anmutung den bekannten Leuchtstoffröhren entsprechen und die auch in den Abmessungen und den Kontaktmitteln (Lampensockel) herkömmlichen Leuchtstofflampen gleich gestaltet sein können. Dies hat den erheblichen Vorteil, dass in den beim Verbraucher vorhandenen Leuchten das bisherige konventionelle Leuchtmittel problemlos durch ein erfindungsgemäßes Leuchtmittel ersetzt werden kann. In gleicher Weise können herkömmliche Glühlampen, auch in Kolben- oder Kerzenform, Energiesparlampen oder Halogenlampen nun durch ein erfindungsgemäßes Leuchtmittel auf OLED-Basis ersetzt werden, welches in Form und Abmessungen jeweils dem herkömmlichen Leuchtmittel entspricht, das es ersetzt.

Eine bevorzugte mögliche konstruktive Variante der erfindungsgemäßen Lösung sieht vor, dass mit Abstand von der Innenfläche des Hohlkörpers in dem Hohlraum separat von der Schichtanordnung die zweite Elektrode angeordnet ist, die als eine der Elektroden der organischen Leuchtdiodenanordnung (OLED) dient. Die auf die Innenfläche des Hohlkörpers aufgebrachte Schichtanordnung muss in diesem Fall nur eine der beiden Elektroden umfassen. Die zweite Elektrode kann beispielsweise etwa punktförmig, kugelförmig oder stabförmig, drahtförmig, ringförmig, flächig oder gitterförmig sein und bei einem annähernd kugelförmigen oder birnenförmigen Hohlkörper etwa in dessen Mittelpunkt angeordnet sein, so dass der Abstand zu der beschichteten inneren Oberfläche in alle Richtungen des Raumes etwa gleich ist. In diesem Fall könnte der Hohlraum mit einem elektrisch leitenden Gas (oder Dampf) befüllt sein, so dass die Ladungsübertragung von der einen zur anderen Elektrode über die in dem Gas enthaltenen Ladungsträger erfolgt. Diese Lösungsvariante kommt auch beispielsweise für etwa zylindrisch geformte Hohlkörper in Betracht. Die zweite Elektrode könnte dann zum Beispiel stabförmig oder drahtförmig sein.

Ein solches in dem Hohlraum befindliches Gas kann weitere positive Auswirkungen auf die Leuchtkraft und/oder die Lebensdauer des Leuchtmittels haben, beispielsweise eine Kühlwirkung. Man kann auch gasförmige Substanzen in den Hohlraum füllen, die im Betrieb des Leuchtmittels selbst leuchtende Eigenschaften haben, wodurch sich beispielsweise auch die Leuchtfarbe des emittierten Lichts beeinflussen oder die Leuchtkraft erhöhen lässt.

Man könnte auch eine zweite Elektrode aus einer elektrisch leitenden Flüssigkeit ausbilden, die man in den Hohlkörper einfüllt. Diese Flüssigelektrode würde dann die zweite mit Abstand von der Schichtanordnung vorgesehene Elektrode gemäß der zuvor genannten Variante und das elektrisch leitende Gas ersetzen.

Zur Erhöhung der Lichtausbeute ist es gemäß einer vorteilhaften Ausgestaltung beispielsweise auch möglich, mehrere Hohlkörper unterschiedlicher Größe der erfindungsgemäßen Art ineinander zu positionieren, beispielsweise mehrere etwa kugelförmige Hohlkörper konzentrisch ineinander oder mehrere zylindrische Hohlkörper koaxial ineinander. Durch diese quasi ineinander geschachtelte Anordnung mehrerer geometrisch ähnlicher Hohlkörper lässt sich bei gleichem Raumbedarf die effektive leuchtende Fläche vergrößern.

Bei einer alternativen bevorzugten konstruktiven Lösungsvariante befinden sich beide Elektroden in der Schichtanordnung auf der inneren Oberfläche des Hohlkörpers wie bei den bislang bekannten OLEDS und die mehrschichtige OLED-Anordnung hat bevorzugt folgenden Schichtaufbau: eine unmittelbar auf die Innenseite des als Träger dienenden Glases aufgebrachte erste lichtdurchlässige Elektrodenschicht (Anode oder Kathode), wenigstens eine auf diese Elektrodenschicht aufgebrachte organische Emitterschicht, wenigstens eine auf die Emitterschicht aufgebrachte zweite Elektrodenschicht. Bevorzugt ist dabei die zweite Elektrodenschicht die oberste (innerste) Schicht der Schichtanordnung, was bedeutet, eine zusätzliche schützende Deckschicht oder Verkapselung kann entfallen, denn der Hohlraum kann ja zur äußeren Umgebung hin abgeschlossen und gegebenenfalls mit einem die OLED-Schichten schützenden Gas befüllt sein.

Das erfindungsgemäße Leuchtmittel ist vorzugsweise außenseitig mit wenigstens einem Lampensockel versehen, wobei hier alle üblichen bekannten Formen von Lampensockeln wie zum Beispiel Schraubsockel, Stecksockel, Bajonettsockel etc. in Betracht kommen. Dadurch wird ein Leuchtmittel geschaffen, welches mit den am Markt befindlichen Fassungssystemen kompatibel ist. Der Sockel weist die für die elektrische Kontaktierung notwendigen Kontakte auf. Bei der zylindrischen Variante sind bevorzugt jeweils an beiden Enden entsprechende Sockel zum Beispiel für eine Steckverbindung oder Drehsteckverbindung entsprechend den für Leuchtstofflampen bekannten Systemen vorgesehen, zum Beispiel über Stifte oder dergleichen.

Gegenstand der vorliegenden Erfindung ist weiterhin ein Verfahren zur Herstellung eines Leuchtmittels, bei dem zunächst ein Hohlkörper aus Glas, Kunststoff oder einem anderen lichtdurchlässigen Material hergestellt wird, der bis auf eine oder mehrere im Verhältnis zur Oberfläche des Hohlkörpers verhältnismäßig kleine Öffnungen geschlossen ist, dann im nächsten Arbeitsschritt die als Träger dienende innere Oberfläche des Hohlkörpers mit einer OLED-Anordnung von einer oder mehreren Schichten versehen wird und dann schließlich die verbleibende(n) Öffnung(en) des Hohlkörpers luftdicht verschlossen wird.

Vorzugsweise erfolgt die Aufbringung mindestens einer der Schichten der OLED-Anordnung durch Bedampfen, Besprühen, Bedrucken der inneren Oberfläche des Hohlkörpers mit dem entsprechenden Beschichtungsmittel oder durch Spin-coating, Sputtern, Sublimation oder ein Beschichtungsverfahren mit Schleudern, Rotieren oder Schütteln des Rotationskörpers. Die letztgenannten Methoden haben den Vorteil, dass so eine gute gleichmäßige Verteilung des Beschichtungsmittels auf der inneren Oberfläche des Hohlkörpers erreicht werden kann. Hier liegt auch ein Vorteil gegenüber herkömmlichen OLEDs, bei denen ein flacher Träger einseitig beschichtet wird, so dass man auf diese Methoden nicht zurückgreifen kann. Außerdem geht bei dem erfindungsgemäßen Verfahren kein Beschichtungsmittel verloren.

Die Schichtanordnung kann auch wenigstens eine weitere Schicht enthalten, die lichtstreuende oder reflektierende Eigenschaften hat und sich gegebenenfalls nur über eine Teilfläche der beschichteten inneren Oberfläche erstreckt. Diese in der Regel äußerste Schicht oder Teilschicht der Schichtanordnung (das heißt unmittelbar auf die innere Oberfläche des Trägers aufgebracht) kann dazu dienen die Lichtabgabe zu variieren und zum Beispiel nur oder verstärkt in bestimmte gewünschte Raumrichtungen zuzulassen.

Es kann auch gemäß einer Variante der Erfindung wenigstens eine weitere Schicht mindestens bereichsweise auf die Oberfläche des Hohlkörpers vor der äußeren Elektrodenschicht aufgebracht wird, die opak, Licht reflektierend, Licht lenkend, die Lichtfarbe verändernd oder Licht streuend ausgebildet ist oder es kann die äußere Elektrodenschicht selbst wenigstens bereichsweise opak, Licht reflektierend, Licht lenkend, die Lichtfarbe verändernd oder Licht streuend ausgebildet sein. Dadurch lassen sich ähnliche Effekte erreichen wie zuvor beschrieben, beispielsweise eine gerichtete Abstrahlung nur in definierten Teilbereichen des Hohlkörpers oder eine veränderte Lichtabstrahlcharakteristik in diesen Teilbereichen.

Die in den Unteransprüchen genannten Merkmale betreffen bevorzugte Weiterbildungen der erfindungsgemäßen Aufgabenlösung. Weitere Vorteile der Erfindung ergeben sich aus der nachfolgenden Detailbeschreibung.

Nachfolgend wird die Erfindung anhand von Ausführungsbeispielen unter Bezugnahme auf die beiliegenden Zeichnungen näher beschrieben. Dabei zeigen:
Figur 1 eine schematisch vereinfachte perspektivische Ansicht eines Leuchtmittels gemäß einer ersten Variante der Erfindung;
Figur 2 eine vergrößerte Schnittdarstellung durch einen Teilausschnitt der Wandung des Hohlkörpers eines Leuchtmittels gemäß einer gegenüber Figur 1 etwas abgewandelten jedoch ähnlichen Lösungsvariante wie in Figur 1;
Figur 3 eine schematisch vereinfachte Seitenansicht eines Leuchtmittels gemäß einer weiteren beispielhaften Ausführungsvariante der Erfindung.

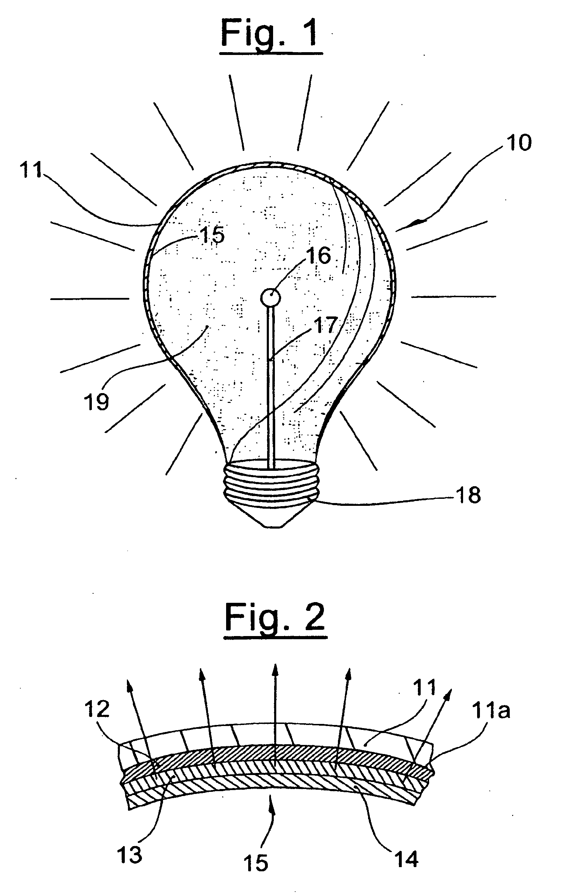

Zunächst wird auf Figur 1 Bezug genommen, die eine prinzipielle Darstellung eines erfindungsgemäßen Leuchtmittels 10 zeigt, welches im Prinzip die äußere geometrische Form einer herkömmlichen Glühlampe aufweist. Das Leuchtmittel umfasst einen Hohlkörper 11 aus Glas in Form eines teilweise etwa kugelförmigen Rotationskörpers (kolbenartige Form oder Birnenform), der als Träger für eine mehrschichtige Schichtanordnung 15 dient, die die organische Leuchtdiode bildet. Die erste Elektrode 12 ist bei der Variante gemäß Figur 1 Teil der Schichtanordnung 15, die auch die bei Anregung das Licht abgebende Emitterschicht enthält. (siehe auch Figur 2). Diese erste Elektrode steht in elektrischer Verbindung mit ersten elektrischen Kontakten, die hier nicht dargestellt sind und die sich beispielsweise im Bereich des Sockels 18 des Leuchtmittels befinden. Dieser Sockel 18 kann nach Art beispielsweise eines Schraubsockels einer gewöhnlichen Glühlampe ausgebildet sein. Die zweite Elektrode der OLED-Anordnung ist bei der Variante von Figur 1 eine quasi punktförmige Elektrode 16 (im Prinzip eine kleine Kugel oder dergleichen), die sich am einen Ende einer etwa stabförmigen Befestigung 17 befindet, welche wiederum mit hier nicht dargestellten zweiten elektrischen Kontakten in Verbindung steht. Um ein elektrisch leitendes Medium zu schaffen, kann der Hohlraum des Hohlkörpers ein elektrisch geladene Partikel, beispielsweise Ionen, enthaltendes gasförmiges Medium 19 enthalten, welches sich reaktionsneutral gegenüber den Schichten 15 der OLED-Anordnung verhält, jedoch den Ladungstransport zwischen den beiden Elektroden 12, 16 zulässt.

In Figur 2 ist in einer Schnittdarstellung ein beispielhafter Aufbau der Schichtanordnung 15 dargestellt für eine gegenüber Figur 1 etwas abgewandelte Variante, bei der beide Elektroden wie bei einer herkömmlichen OLED in dem Schichtaufbau enthalten sind, so dass hier die in Figur 1 gezeigte Elektrode 16 und das leitende Medium 19 im Hohlraum entfallen können. Diese Schichtanordnung 15 umfasst eine erste äußere Elektrodenschicht 12, die auf das als Träger dienende Glas und somit auf die innere Oberfläche 11 a des Hohlkörpers 11 aufgebracht ist, beispielsweise aufgedampft ist. Auf die erste Elektrodenschicht 12 ist eine Emitterschicht 13 aufgebracht, beispielsweise durch Sublimation oder Aufdampfen. Diese Emitterschicht 13 ist die den organischen Stoff enthaltende Schicht, die bei Anregung das Licht in der gewünschten Lichtfarbe abgibt. Diese Emitterschicht kann-mehrschichtig und komplexer aufgebaut sein, ebenso wie die Elektrodenschicht 12, was jedoch in der vereinfachten Darstellung gemäß dem Schnitt von Figur 2 nicht dargestellt ist. Auf die Emitterschicht 13 aufgebracht ist schließlich die zweite Elektrodenschicht 14, die ebenfalls eventuell mehrschichtig aufgebaut sein kann, was hier nicht dargestellt ist. Dieser Aufbau von mindestens drei Schichten 12, 13, 14 bildet bei dieser Variante der Erfindung die OLED-Schichtanordnung, die bei Anregung durch den transparenten oder wenigstens transluzenten aus Glas bestehenden Hohlkörper 11 hindurch nach außen hin Licht im Prinzip in alle Richtungen des Raumes abgibt. Da die Emitterschicht 13 nach außen hin von der ersten Elektrodenschicht 12 abgedeckt wird, ist diese Schicht 12 in der Regel auch transparent, um den Lichtdurchtritt zuzulassen. Entsprechende transparente Elektroden sind aus den herkömmlichen OLEDs bekannt.

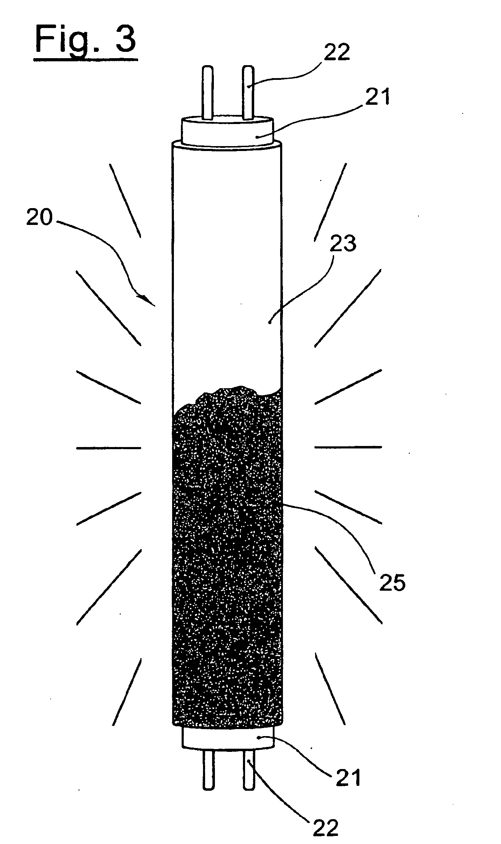

Nachfolgend wird unter Bezugnahme auf Figur 3 eine weitere alternative Ausführungsvariante eines erfindungsgemäßen Leuchtmittels beschrieben. Die Darstellung zeigt eine teilweise aufgebrochene Seitenansicht eines Leuchtmittels 20, welches die zylindrische Geometrie und die Anmutung einer konventionellen stabförmigen Leuchtstofflampe aufweist. Es sind an beiden Enden jeweils Lampensockel 21 mit Steckkontakten 22 vorgesehen, so dass das Leuchtmittel 20 in einer herkömmlichen Fassung für eine Leuchtstofflampe befestigt werden kann. Das Leuchtmittel ist als im wesentlichen zylindrischer Hohlkörper 23 aus Glas ausgebildet, auf dessen innere Oberfläche eine mehrschichtige Schichtanordnung 25 aufgebracht ist, zum Beispiel durch Aufdampfen, die beispielsweise den in Figur 2 für die Schichtanordnung gezeigten Schichtaufbau aufweist. Auf die obigen Ausführungen zu Figur 2 wird verwiesen. Die beiden in diesem Schichtaufbau der Schichtanordnung 25 enthaltenen Elektroden stehen in elektrisch leitender Verbindung mit den jeweiligen Steckkontakten 22 der Leuchtstofflampe. Auch bei dieser Variante befinden sich die OLED-Schichten in einem geschlossenen Hohlraum, wobei der zylindrische Hohlkörper 23 bereits als Träger für die äußere Schicht der Schichtanordnung dient. Da der Hohlraum nach außen hin luftdicht abgeschlossen ist, ist eine Verkapselung der innersten Schicht nicht notwendig. Auch hier besteht der Hohlkörper 23 aus Glas und ist transparent oder transluzent, so dass das Licht durch das Glas nach außen in im Prinzip alle Raumrichtungen abgegeben werden kann. Das Leuchtmittel 20 bildet somit ein stabförmiges Leuchtmittel, welches mit einer herkömmlichen Leuchtstofflampe kompatibel ist und folglich einen problemlosen Austausch zulässt.

## Patentansprüche

1. Verfahren zur Herstellung eines Leuchtmittels auf Basis organischer Leuchtdioden (OLED) umfassend wenigstens eine organische Licht emittierende Schicht (OLED-Schicht) sowie mindestens eine Anodenschicht und/oder eine Kathodenschicht auf, an oder in einem Träger sowie Kontaktmittel für eine elektrische Kontaktierung der Elektrodenschichten,
wobei eine Schicht oder Schichtanordnung (15) umfassend mindestens die Licht emittierende Schicht (13) auf die Innenseite einer als Träger dienenden formstabilen Rotationsfläche aufgebracht ist,
und wobei als Träger die Innenfläche eines weitgehend oder vollständig geschlossenen Hohlkörpers (11, 23) aus Glas, Kunststoff, Keramik oder einem anderen lichtdurchlässigen Material dient, **dadurch gekennzeichnet, dass** zunächst ein Hohlkörper aus Glas, Kunststoff, Keramik oder einem anderen lichtdurchlässigen Material hergestellt wird, der bis auf eine oder mehrere im Verhältnis zur Oberfläche des Hohlkörpers verhältnismäßig kleine Öffnungen geschlossen ist, dass im nächsten Arbeitsschritt die als Träger dienende innere Oberfläche des Hohlkörpers (11) mit einer OLED-Anordnung (15) von einer oder mehreren Schichten versehen wird, indem eine Beschichtungseinrichtung in den Hohlkörper eingeführt wird und das Beschichtungsmaterial von einem Sprühkopf aus in alle Raumrichtungen ***gleichmäßig*** verteilt und auf der zu beschichtenden Fläche ***gleichmäßig*** niedergeschlagen wird und dass schließlich die verbleibende(n) Öffnung(en) des Hohlkörpers luftdicht verschlossen wird.

2. Verfahren nach Anspruch 1, **dadurch gekennzeichnet, dass** die Innenfläche (11 a) eines mindestens abschnittsweise kugelförmigen, zylindrischen, ellipsoiden, kolbenförmigen oder kerzenförmigen Rotationskörpers (11, 23) mit der OLED-Schicht (13) beschichtet wird und dieser Rotationskörper weiter mit mindestens einer Elektrodenschicht (12, 14) beschichtet wird oder der Träger selbst mindestens eine Elektrodenschicht umfasst.

3. Verfahren nach einem der Ansprüche 1 oder 2, **dadurch gekennzeichnet, dass** die Innenfläche des als Substrat dienenden starren Trägers (11, 23) unmittelbar mit mindestens einer der für die Funktion der organischen Leuchtdiode wesentlichen Schichten, vorzugsweise mit einer der Elektrodenschichten (12), durch besprühen versehen wird.

4. Verfahren nach einem der Ansprüche 1 bis 3, **dadurch gekennzeichnet, dass** im wesentlichen die gesamte verfügbare Innenfläche oder nur eine definierte Teilfläche des als Hohlkörper ausgebildeten Trägers mit einer ein- oder mehrschichtigen Anordnung (15) der für die Funktion der organischen Leuchtdiode wesentlichen Schichten bedeckt wird.

5. Verfahren nach einem der Ansprüche 1 bis 4, **dadurch gekennzeichnet, dass** das Leuchtmittel die Form einer Glühlampe (10), Leuchtstoffröhre (20), Kolbenlampe, Kugellampe, Kerzenlampe oder dergleichen aufweist.

6. Verfahren nach einem der Ansprüche 1 bis 5, **dadurch gekennzeichnet, dass** mit Abstand von der Innenfläche des Hohlkörpers (11) in dem Hohlraum separat von der Schichtanordnung wenigstens eine zweite Elektrode (16) angeordnet wird, die als eine der Elektroden der organischen Leuchtdiodenanordnung (OLED) dient.

7. Verfahren nach einem der Ansprüche 1 bis 6, **dadurch gekennzeichnet, dass** eine mehrschichtige OLED-Anordnung (15) mit folgendem Schichtaufbau hergestellt wird: einer unmittelbar auf die Innenseite des Trägers aufgebrachten ersten transparenten Elektrodenschicht (12) (Anode oder Kathode), wenigstens einer auf diese Elektrodenschicht aufgebrachten organischen Emitterschicht (13), wenigstens einer auf die Emitterschicht aufgebrachten zweiten Elektrodenschicht (14).

8. Verfahren nach einem der Ansprüche 1 bis 7, **dadurch gekennzeichnet, dass** der Hohlkörper (11, 23) mit wenigstens einem Lampensockel (18, 21) versehen wird.

9. Verfahren nach einem der Ansprüche 1 bis 8, **dadurch gekennzeichnet, dass** wenigstens eine zweite Elektrode eine annähernd punktförmige Elektrode (16) ist, welche vorzugsweise etwa im Mittelpunkt des Hohlkörpers angeordnet wird.

10. Verfahren nach Anspruch 9, **dadurch gekennzeichnet, dass** der Hohlkörper (11) die Form einer Kugel oder eine von der Kugelform abgeleitete Form mit Kugelabschnitt und
angeformtem Halsbereich (insbesondere Kolbenform, Birnenform) aufweist und wenigstens eine zweite Elektrode (16) etwa im Mittelpunkt der Kugel oder des Kugelabschnitts angeordnet wird.

11. Verfahren nach einem der Ansprüche 1 bis 10, **dadurch gekennzeichnet, dass** der Hohlkörper (23) etwa die Form eines Zylinders aufweist und an einem Ende ein Lampensockel oder an beiden Enden in den stirnseitigen Bereichen jeweils ein Lampensockel (21) mit Kontaktmitteln (22) für die elektrische Kontaktierung vorgesehen wird, wobei eine gegebenenfalls vorhandene zweite stabförmige, drahtförmige oder ringförmige Elektrode etwa im Bereich der Mittelachse des Hohlkörpers angeordnet wird.

12. Verfahren zur Herstellung eines Leuchtmittels nach einem der Ansprüche 1 bis 11, **dadurch gekennzeichnet, dass** wenigstens eine weitere Schicht aufgebracht wird, die lichtstreuende, lichtlenkende, reflektierende oder die Lichtfarbe verändernde Eigenschaften hat und sich gegebenenfalls nur über eine Teilfläche der beschichteten inneren Oberfläche des Hohlkörpers erstreckt.

13. Verfahren nach einem der Ansprüche 1 bis 12, **dadurch gekennzeichnet, dass** wenigstens eine weitere Schicht mindestens bereichsweise auf die Oberfläche des Hohlkörpers vor der äußeren Elektrodenschicht aufgebracht wird, die opak, Licht reflektierend, Licht lenkend, die Lichtfarbe verändernd oder Licht streuend ausgebildet ist, dass die äußere Elektrodenschicht wenigstens bereichsweise opak, Licht reflektierend oder Licht streuend ausgebildet ist, oder in dem Hohlraum zusätzliche Licht lenkende, Licht streuende, Licht reflektierende oder die Lichtfarbe verändernde Elemente angeordnet sind.

## Claims

1. A method of producing a luminant based on organic light-emitting diodes (OLED) comprising at least one organic light-emitting layer (OLED layer) and at least one anode layer and/or a cathode layer, on or in a carrier and also contacting agents for an electrical contact-connection of the electrode layers,
wherein one layer or layer assembly (15) comprising at least the light-emitting layer (13) is applied to the inside of a dimensionally stable rotational surface acting as the carrier,
and wherein the inner surface of a largely or completely closed hollow body (11, 23) made from glass, plastic, ceramic or another light-permeable material acts as the carrier, **characterised in that** a hollow body made from glass, plastic, ceramic or another light-permeable material is made first, which is closed apart from one or several openings that are comparatively small in relation to the surface of the hollow body, that in the next production step the inner surface of the hollow body (11) acting as the carrier is provided with an OLED assembly (15) of one or more layers, **in that** a coating mechanism is introduced into the hollow body and the coating material is equally distributed from a spray head in all spatial directions and is equally deposited on the surface being coated and that the remaining opening(s) in the hollow body are finally closed.

2. The method according to claim 1, **characterised in that** the inner surface (11a) of a rotational body (11, 23), at least sections of which are spherical, cylindrical, ellipsoidal, bulb-shaped or candle-shaped, are coated with the OLED layer (13) and this rotational body is further coated with at least one electrode layer (12, 14) or the carrier itself comprises at least one electrode layer.

3. The method according to one of the claims 1 or 2, **characterised in that** the inner surface of the rigid carrier (11, 23) acting as the substrate is directly provided with at least one of the layers essential to the function of the organic light-emitting diode, preferably with one of the electrode layers (12), by spraying.

4. The method according to one of the claims 1 to 3, **characterised in that** essentially the entire available inner surface or only a defined partial surface of the carrier formed as the hollow body is covered with a single or multi-layer assembly (15) of layers essential to the function of the organic light-emitting diode.

5. The method according to one of the claims 1 to 4, **characterised in that** the luminant exhibits the form of a filament bulb (10), fluorescent tube (20), beam bulb, sphere lamp, candle bulb or similar.

6. The method according to one of the claims 1 to 5, **characterised in that** at least a second electrode (16) is disposed in the hollow space separately from the layer assembly spaced from the inner surface of the hollow body (11), said electrode acting as one of the electrodes of the organic light-emitting diode (OLED) assembly.

7. The method according to one of the claims 1 to 6, **characterised in that** a multi-layer OLED assembly (15) is produced with the following layer structure: a first transparent electrode layer (12) (anode or cathode) applied directly to the inside of the carrier, at least one organic emitter layer (13) applied to this electrode layer, at least one second electrode layer (14) applied to the emitter layer.

8. The method according to one of the claims 1 to 7, **characterised in that** the hollow body (11, 23) is provided with at least one lamp base (18, 21).

9. The method according to one of the claims 1 to 8, **characterised in that** at least a second electrode is an approximately punctiform electrode (16), which is preferably disposed roughly in the centre of the hollow body.

10. The method according to claim 9, **characterised in that** the hollow body (11) exhibits the form of a sphere or a shape derived from the spherical form with a spherical section and a neck area moulded on (particularly a piston shape, bulb shape) and at least one second electrode (16) is disposed roughly in the centre of the sphere or the spherical section.

11. The method according to one of the claims 1 to 10, **characterised in that** the hollow body (23) exhibits approximately the shape of a cylinder and a lamp base is provided at one end or lamp bases (21) are provided at both ends in the front areas with contacting means (22) for the electrical contact-connection, wherein a second rod-shaped, wire-shaped or ring-shaped electrode that may be present is disposed roughly in the area of the centre axis of the hollow body.

12. The method of producing a luminant according to one of the claims 1 to 11, **characterised in that** at least one further layer is applied, which has light-dispersing, light-directing, reflecting or light-colour-changing properties and possibly only extends over a partial area of the coated inner surface of the hollow body.

13. The method according to one of the claims 1 to 12, **characterised in that** at least one further layer is applied at least in sections to the surface of the hollow body in front of the outer electrode layer, which is designed to be opaque, light-reflecting, light-directing, light-colour-changing or light-dispersing, that the outer electrode layer is designed to be opaque, light-reflecting or light-dispersing, at least in parts, or additional light-directing, light-dispersing, light-reflecting or light-colour-changing elements are disposed in the hollow space.

## Revendications

1. Procédé pour fabriquer un luminaire sur la base de diodes électroluminescentes organiques (OLED) comprenant au moins une couche organique émettant de la lumière (couche OLED) et au moins une couche d'anode et/ou une couche de cathode, sur ou dans un support ainsi que des moyens de contact pour l'établissement d'un contact électrique avec les couches d'électrode,
au moins une couche ou un agencement de couche (15) comprenant au moins la couche (13) émettant de la lumière étant appliqué sur le coté intérieur d'une surface de rotation indéformable et servant de support,
et la surface intérieure d'un corps creux (11, 23) largement ou complètement fermé à base de verre, plastique, céramique ou d'un autre matériau transparent servant de support, **caractérisé en ce que** d'abord un corps creux en verre, plastique, céramique ou à base d'un autre matériau transparent est fabriqué, lequel corps est fermé à l'exception d'une ou de plusieurs ouvertures relativement petites par rapport à la surface du corps creux, **en ce que**, dans la première étape de travail, la surface intérieure servant de support du corps creux (11) est dotée d'un agencement OLED (15) d'une ou plusieurs couches, par le fait qu'un dispositif de revêtement est introduit dans le corps creux et répartit le matériau de revêtement à partir d'une tête de pulvérisation régulièrement dans toutes les directions dans l'espace et est déposé régulièrement sur la surface à revêtir et **en ce qu'**enfin l'ouverture (les ouvertures) restante(s) du corps creux est (sont) fermée(s) de façon hermétiques.

2. Procédé selon la revendication 1, **caractérisé en ce que** la surface intérieure (11a) d'un corps de rotation (11, 23) au moins par endroits sphérique, cylindrique, ellipsoïdal, en forme de ballon ou de flamme est revêtu avec la couche OLED (13) et ce corps de rotation est revêtu également avec au moins une couche d'électrode (12, 14) ou bien le support même comprend au moins une couche d'électrode.

3. Procédé selon l'une quelconque des revendications 1 ou 2, **caractérisé en ce que** la surface intérieure du support (11, 23) rigide servant de substrat est dotée directement d'au moins une des couches importantes pour la fonction de la diode électroluminescente organique, de préférence d'une des couches d'électrode (12), par pulvérisation.

4. Procédé selon l'une quelconque des revendications 1 à 3, **caractérisé en ce que**, pour l'essentiel, l'ensemble de la surface intérieure disponible ou seulement une surface partielle définie du support conçu comme corps creux est revêtu d'un agencement (15) monocouche ou multicouche des couches importantes pour la fonction de la diode électroluminescente organique.

5. Procédé selon l'une quelconque des revendications 1 à 4, **caractérisé en ce que** le luminaire présente la forme d'une lampe à incandescence (10), d'un tube fluorescent (20), d'une lampe ballon, d'une lampe sphérique, d'une lampe flamme ou similaire.

6. Procédé selon l'une quelconque des revendications 1 à 5, **caractérisé en ce qu'**au moins une seconde électrode (16), qui fait office de l'une des électrodes de l'agencement de diode électroluminescente organique (OLED), est disposée à distance de la surface intérieure du corps creux (11) dans la cavité séparément de l'agencement de couche.

7. Procédé selon l'une quelconque des revendications 1 à 6, **caractérisé en ce qu'**un agencement OLED (15) multicouche est fabriqué avec la structure de couche suivante : une première couche d'électrode (12) transparente (anode ou cathode) appliquée directement sur le côté intérieur du support, au moins une couche d'émetteur (13) organique appliquée sur cette couche d'électrode, au moins une seconde couche d'électrode (14) appliquée sur la couche d'émetteur.

8. Procédé selon l'une quelconque des revendications 1 à 7, **caractérisé en ce que** le corps creux (11, 23) est doté d'au moins un socle de lampe (18, 21).

9. Procédé selon l'une quelconque des revendications 1 à 8, **caractérisé en ce qu'**au moins une seconde électrode est une électrode (16) approximativement de forme ponctuelle, qui est disposée de préférence à peu près au centre du corps creux.

10. Procédé selon la revendication 9, **caractérisé en ce que** le corps creux (11) présente la forme d'une sphère ou une forme déduite de la forme sphérique avec partie sphérique et zone de col formée dessus (en particulier forme de ballon, forme de poire) et au moins une seconde électrode (16) est disposée à peu près au centre de la sphère ou de la partie sphérique.

11. Procédé selon l'une quelconque des revendications 1 à 10, **caractérisé en ce que** le corps creux (23) présente à peu près la forme d'un cylindre et un socle de lampe est prévu sur une extrémité ou un socle de lampe (21) est prévu sur chacune des deux extrémités dans les zones avant avec des moyens de contact (22) pour l'établissement d'un contact électrique, une seconde électrode éventuellement présente, en forme de barre, en forme de fil ou de bague étant disposée à peu près au centre de l'axe médian du corps creux.

12. Procédé pour fabriquer un luminaire selon l'une quelconque des revendications 1 à 11, **caractérisé en ce qu'**au moins une autre couche est appliquée, laquelle a des propriétés diffusant la lumière, guidant la lumière, réfléchissantes ou modifiant la couleur de la lumière, et s'étend éventuellement seulement sur une surface partielle de la surface intérieure revêtue du corps creux.

13. Procédé selon l'une quelconque des revendications 1 à 12, **caractérisé en ce qu'**au moins une autre couche est appliquée au moins par endroits sur la surface du corps creux avant la couche d'électrode extérieure, qui est opaque, réfléchit la lumière, guide la lumière, modifie la couleur de la lumière ou diffuse la lumière, **en ce que** la couche d'électrode extérieure est opaque au moins par endroits, réfléchit la lumière ou diffuse la lumière, ou bien des éléments supplémentaires guidant la lumière, diffusant la lumière, réfléchissant la lumière ou modifiant la couleur de la lumière sont disposés dans la cavité.
